# FASCICULE DE BREVET EUROPEEN

(11) **EP 1 019 744 B1**
(45) Date de publication et mention de la délivrance du brevet: **20.08.2003**
(21) Numéro de dépôt: 98951465.8
(22) Date de dépôt: 24.09.1998
(51) Int. Cl.: G01R 31/36

(54) **PROCEDE DE DETECTION DE DEFAILLANCE D'UNE BATTERIE DE VEHICULE AUTOMOBILE**
VERFAHREN ZUR FEHLERERKENNUNG EINER KRAFTFAHRZEUGBATTERIE
METHOD FOR DETECTING A MOTOR VEHICLE BATTERY FAILURE

(30) Priorité: 01.10.1997 FR 9712213
(43) Date de publication de la demande: 19.07.2000
(73) Titulaire: Siemens VDO Automotive S.A.S., 31036 Toulouse Cédex 01 (FR)
(72) Inventeur: MEYER, Henry-Louis, F-31170 Tournefeuille (FR)
(74) Mandataire: Berg, Peter, Dipl.-Ing.
(86) Numéro de dépôt international: EP9806103
(87) Numéro de publication internationale: WO99017128

(56) Documents cités:
- EP-A- 0 464 748
- WO-A-91/16635
- DE-A- 3 901 680
- DE-A- 4 341 826
- US-A- 5 193 067

## Description

La présente invention est relative à un procédé de détection de défaillance d'une batterie de véhicule automobile. Plus particulièrement, le procédé selon l'invention est destiné à être implanté dans un calculateur électronique embarqué dans un véhicule automobile, et à avertir le conducteur d'une défaillance prochaine de la batterie.

Il existe déjà un certain nombre de procédés de détection de défaillance de batterie. Les procédés les plus connus consistent à mesurer la tension de décharge de la batterie lorsque celle ci est déconnectée du véhicule. Ceci n'est guère pratique pour une surveillance régulière de l'état de charge de la batterie.

Il existe également des procédés de détection de défaillance d'une batterie implantés dans un calculateur électronique embarqué à bord d'un véhicule et ne nécessitant pas de déconnexion de la batterie. Un tel procédé est par exemple décrit dans le document US 4 937 528. Cependant, la mise en oeuvre de ce procédé nécessite la surveillance d'un nombre important de paramètres et donc l'adjonction de capteurs spécifiques, ce qui augmente d'autant le coût de réalisation.

Le document FR 2 694 660 décrit, quant à lui, un dispositif de détection de défaillance d'éléments de batterie pour une batterie destinée à alimenter un dispositif d'alimentation sans coupure. Un tel dispositif n'est pas destiné à être mis en oeuvre dans un véhicule automobile. Ce document enseigne cependant comment mesurer l'évolution de la tension de décharge de la batterie dans le temps pour déterminer tous signes de défaillance. A cet effet, on présuppose que la tension de décharge varie quasi linéairement dans le temps. Mais dans le cas d'une batterie alimentant un véhicule automobile, la tension de décharge de la batterie pendant la phase de démarrage du moteur est largement perturbée par le fonctionnement du moteur. Notamment, cette tension de décharge n'est pas une fonction linéaire du temps. En effet, le fonctionnement du moteur provoque des oscillations importantes de cette tension de décharge pendant la phase de démarrage. De ce fait, le simple suivi à des intervalles de temps déterminés de l'évolution de la tension de décharge de la batterie n'est pas directement significatif de son état de charge et les enseignements du document FR 2 694 660 ne sont pas applicables.

Le document DE 3901680 décrit un procédé de surveillance de la possibilité de démarrage à froid d'une batterie de moteur à combustion interne. A cet effet, il est proposé de mesurer l'évolution de la tension batterie pendant la phase de démarrage et de déduire, de la différence entre la tension maximum et la tension minimum mesurée, l'état de charge de la batterie. Cependant, ces tensions maximum et minimum sont mesurées à des instants quelconques du cycle de combustion, et leur différence arithmétique est donc fonction de l'état de la batterie et des fluctuations normales du cycle de combustion. Un tel procédé de mesure ne permet pas de s'affranchir des perturbations liées au cycle de combustion du moteur.

Le but de la présente invention est de pallier ces inconvénients et notamment de proposer un procédé de détection de défaillance de batterie de véhicule automobile pendant la phase d'entraînement du moteur, le dit procédé étant notamment capable de s'affranchir des perturbations liées au cycle de combustion du moteur. On cherche en outre à mesurer le moins de paramètres possibles et à ne pas utiliser de capteurs spécifiques. En cas de défaillance légère (c'est-à-dire n'ayant pas entraîné la non mise en route du véhicule), on désire que le conducteur soit tout de même averti de l'état de faible charge de la batterie afin d'effectuer une recharge ou un changement de batterie avant que celle-ci ne soit totalement vide.

A cet effet, la présente invention concerne un procédé de détection de défaillance d'une batterie de véhicule automobile du type consistant à analyser l'évolution de la tension de décharge aux bornes de la batterie en fonction du temps, caractérisé en ce qu'il consiste à :
- mesurer deux valeurs successives (U₁, U₂) de la tension de décharge de la batterie, pendant la phase d'entraînement du moteur du véhicule automobile, lors de deux points morts hauts consécutifs,
- effectuer une différence des valeurs de tension mesurées, et
- en déduire si la batterie est chargée ou défaillante.

Ainsi, en effectuant des mesures de la tension de décharge à des instants bien déterminés du cycle de combustion moteur, il est possible de mettre en évidence des signes de défaillance de la batterie, sans capteurs spécifiques, et en s'affranchissant des perturbations liées au cycle de combustion du moteur. La mesure de la tension batterie est, en effet, déjà utilisée dans les calculateurs de commande de fonctionnement moteur.

Le fait de réaliser les mesures de la tension de décharge de la batterie en ces points de fonctionnement spécifiques permet de déterminer très rapidement (pendant les quelques tours moteur de la phase d'entraînement) si la batterie est correctement chargée ou non. En effet, la mesure de la tension de la batterie en dehors de la phase de démarrage est perturbée par le fait qu'une fois le moteur démarré, la batterie est rechargée par l'altemateur. Il est donc beaucoup plus compliqué d'essayer de déterminer l'état de charge de la batterie et surtout sa capacité à assurer un démarrage correct du véhicule en dehors de la phase d'entraînement du moteur. l'état de charge de la batterie et surtout sa capacité à assurer un démarrage correct du véhicule en dehors de la phase d'entraînement du moteur,

On notera que l'indication d'une défaillance de la batterie est donnée par une simple différence entre les valeurs de la tension en deux points de fonctionnement spécifiques consécutifs.

D'autres objets, avantages et caractéristiques de l'invention ressortiront d'ailleurs de la description qui suit, à titre d'exemple non limitatif, et en référence aux dessins annexés, dans lesquels :
- la figure 1 est une vue schématique représentant l'évolution de la tension de décharge aux bornes d'une batterie pendant les phases de démarrage et de mise en route, lorsque la batterie est correctement chargée,
- la figure 2 est une vue schématique, analogue à la figure 1, pour une batterie faiblement déchargée ou partiellement usagée,
- la figure 3 est une vue schématique, analogue à la figure 1, pour une batterie très fortement déchargée ou très usagée,
- la figure 4 illustre le procédé de détection de défaillance, selon l'invention, dans le cas d'une batterie très fortement déchargée, et
- les figures 5a et 5b illustrent de manière schématique respectivement, l'évolution de la tension d'une batterie, et l'évolution de la moyenne progressive de cette même tension.

Nous allons tout d'abord rappeler quelle est l'évolution de la tension aux bornes d'une batterie lors du démarrage du véhicule automobile.

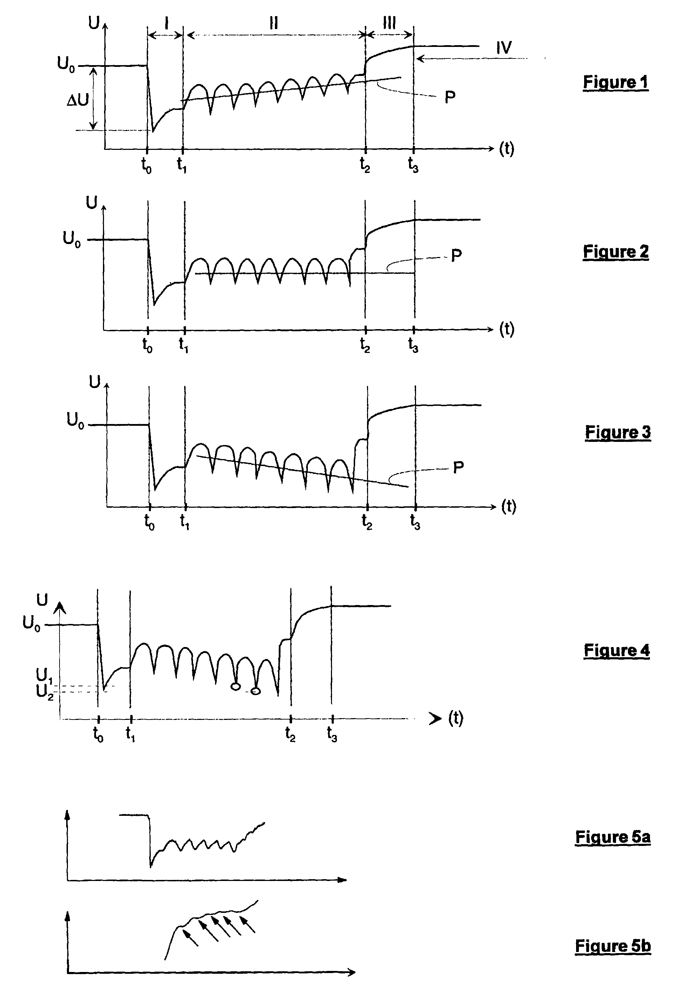

En référence à la figure 1, avant le démarrage du véhicule, la tension U₀ débitée par la batterie est mémorisée. Ensuite, la tension U délivrée par la batterie est sollicitée lors de la phase de mise en route mécanique (phase I). On a matérialisé par une ligne verticale l'instant t₀ où le conducteur tourne sa clef de contact dans la serrure de contact. Le contacteur du démarreur vient de se fermer, ce qui entraîne une forte pointe de courant et une chute correspondante de la tension aux bornes de la batterie. Cette chute de tension ΔU n'est que partiellement liée à l'importance de la décharge de la batterie et à son vieillissement.

A l'instant t₁ (phase II), le démarreur commence à entraîner le moteur thermique. La tension de la batterie présente alors des ondulations sensiblement synchronisées avec les compressions du moteur. Cette phase d'entraînement moteur se caractérise donc par une série d'ondulations. Chacun des minima successifs correspond à une compression du moteur thermique.

Dès que le moteur thermique a démarré (ce qu'il fait au bout d'environ huit compressions, parfois moins), la tension commence à remonter. On se trouve alors dans la phase III de démarrage du moteur.

Lorsque le moteur tourne suffisamment vite, l'alternateur commence alors à débiter du courant et la tension aux bornes de la batterie se stabilise (phase IV dite de mise en route stabilisée).

En fonction de la phase pendant laquelle la tension batterie est mesurée, on conçoit facilement que la mesure de la tension batterie doit être interprétée différemment.

Selon la présente invention, on a remarqué que pendant la phase d'entraînement moteur (phase II), la pente moyenne (P) de la pluralité d'ondulations peut être de trois types différents. Pour plus de clarté, cette pente P a été schématisée dans les dessins par une droite P.

Comme cela est représenté à la figure 1, cette pente P peut être ascendante. Dans ce cas, les minima de tension relevés pour des compressions moteur successives (points morts hauts consécutifs) sont croissants. Une telle courbe met en évidence une batterie correctement chargée.

Dans le cas de la figure 2, on remarque que les minima successifs sont globalement constants. La droite P représentant la pente de cette courbe est horizontale. Une telle courbe est caractéristique d'une batterie faiblement chargée ou partiellement usagée. Une telle batterie nécessite au moins une recharge.

Dans le cas de la figure 3, on remarque que les minima successifs sont globalement décroissants. La pente P de cette courbe est décroissante et est caractéristique d'une batterie très fortement déchargée ou très usagée. Une telle batterie doit être changée, et/ou rechargée.

Selon l'invention, en tenant compte des faits illustrés aux figures 1 à 3, le procédé de détection de défaillance consiste à (figure 4) :
- mesurer au moins deux valeurs successives U₁, U₂ de la tension de décharge de la batterie, pendant la phase d'entraînement du moteur automobile, à des instants t₁, t₂ où le moteur se trouve en un point de fonctionnement spécifique (par exemple, point mort haut),
- effectuer la différence U₁ - U₂ des valeurs de tension mesurées, et
- en déduire si la batterie est chargée ou défaillante, en fonction du signe de cette différence.

En effet, lorsque la différence est supérieure à zéro cela signifie que U₁ est supérieur à U₂. Or, dans ce cas, la pente P est décroissante. On se trouve donc dans le cas représenté à la figure 4 et la batterie est très fortement déchargée.

Par contre, lorsque la différence U₁ - U₂ est inférieure à zéro, alors U₁ est inférieure à U₂ et la pente P est croissante. Dans ce cas (représenté à la figure 1), la batterie est correctement chargée.

Enfin, dans le cas où la différence U₁ - U₂ est nulle, c'est que U₁ est égal à U₂. La pente de la courbe est donc nulle (droite horizontale) et la batterie est considérée comme faiblement chargée et nécessite une recharge.

Ainsi, en effectuant simplement des mesures de la tension de décharge lors de deux points morts hauts successifs, il est possible de tracer une courbe dont la pente P est représentative du degré de charge de la batterie.

En variante (figures 5a et 5b), il est possible de tracer la moyenne progressive de la tension mesurée aux bornes de la batterie. Cette moyenne est représentée à la figure 5b. Dans ce cas, lorsque la dérivée première de cette moyenne est inférieure ou égale à zéro, il y a détection d'une défaillance batterie.

L'analyse de cette moyenne est réalisée de manière classique en ce qui concerne l'obtention des dérivées première et seconde et ne sera pas détaillée ici.

En utilisant la moyenne progressive de la tension mesurée, on effectue en fait un filtrage des mesures de la tension de telle sorte que les ondulations dues aux compressions moteur pendant la phase II d'entraînement soient minimisées. On rappelle que la moyenne progressive de la tension est une moyenne effectuée sur les N points de mesure de la tension instantanée précédant la mesure en cours.

On notera qu'il est en outre possible de confirmer une défaillance batterie préalablement détectée si la moyenne des tensions de décharge lors de la phase d'entraînement est inférieure à un seuil prédéterminé en fonction d'une température de batterie.

De même, on peut déclarer que la batterie est « vieille » si la batterie est déclarée défaillante et qu'une moyenne des tensions de décharge pendant la phase d'entraînement est inférieure à un seuil prédéterminé en fonction de la température, et, dans ce cas, de préférence on informe le conducteur qu'il va devoir changer la batterie sous peu.

On notera que la mesure de la tension U₀ débitée par la batterie avant mise sous contact permet déjà de déterminer si la batterie est vide ou vieille. En effet, si cette tension U₀ est inférieure à des seuils déterminés, on peut supposer qu'il existe un défaut (déchargée, usagée). Par contre, lorsque la tension U₀ est supérieure aux seuils déterminés, cela ne signifie pas automatiquement que la batterie est en bon état. Dans ce cas, le procédé selon l'invention permet de poursuivre l'analyse et de détecter des défauts de charge ou de vieillesse cachés. Il est possible de prévoir une recharge renforcée pendant le roulage du véhicule, lorsqu'un défaut de charge (même léger) a été mis en évidence par le procédé selon la présente invention. Cette recharge renforcée est réalisée par un pilotage approprié de l'alternateur par exemple et associée ou non à une limitation de la consommation des accessoires (chauffage, autoradio, ...).

Bien entendu, la présente invention n'est pas limitée aux modes de réalisation ci-dessus décrits. Ainsi, la mesure de la tension batterie pourrait être effectuée en d'autres points spécifiques du cycle moteur. L'important ici est de réaliser des mesures consécutives de la tension batterie en des instants correspondants d'au moins deux cycles moteur consécutifs.

## Revendications

1. Procédé de détection de défaillance d'une batterie de véhicule automobile, le dit véhicule comportant un moteur à combustion interne entraîné en rotation pendant une phase d'entraînement par un démarreur branché sur la batterie du véhicule, cette phase d'entraînement se déroulant pendant une phase de démarrage du moteur, le dit procédé consistant à analyser l'évolution de la tension de décharge aux bornes de la batterie en fonction du temps et comportant les étapes suivantes :
- mesure de deux valeurs successives respectivement U₁ et U₂ de la tension de décharge de la batterie pendant la phase d'entraînement du moteur du véhicule automobile,
- calcul de la différence des valeurs de tensions mesurées, et
- détermination de l'état de charge de la batterie à partir de cette différence,
le dit procédé étant **caractérisé en ce que** la mesure des deux valeurs successives, respectivement U₁ et U₂, est réalisée en des instants correspondants de deux cycles moteur consécutifs et **en ce que** la différence de tension formée est strictement U₁ - U₂.

2. Procédé selon la revendication 1, **caractérisé en ce que** les instants correspondants de deux cycles moteur consécutifs sont des points mort hauts.

3. Procédé de détection selon la revendication 1 ou 2, **caractérisé en ce que** la batterie est déclarée défaillante si la différence des tensions mesurées U₁ - U₂ est inférieure ou égale à zéro.

4. Procédé de détection selon la revendication 1, **caractérisé en ce qu'**il consiste en outre à :
- calculer la moyenne progressive des tensions (U₁ ; U₂) de décharge mesurées, et
- en déduire que la batterie est défaillante si la dérivée première de cette moyenne est inférieure ou égale à zéro.

5. Procédé de détection selon l'une quelconque des revendications précédentes, **caractérisé en ce qu'**il consiste à :
- confirmer la défaillance de la batterie si la moyenne des tensions de décharge lors de la phase d'entraînement est inférieure à un seuil prédéterminé en fonction d'une température de batterie.

6. Procédé de détection selon l'une quelconque des revendications 1 à 4, **caractérisé en ce qu'**il consiste à :
- déclarer que la batterie est « vieille » si la batterie est déclarée défaillante et qu'une moyenne des tensions de décharge pendant la phase d'entraînement est inférieure à un seuil prédéterminé en fonction de la température, permettant d'informer le conducteur qu'il va devoir changer la batterie sous peu.

## Patentansprüche

1. Verfahren zum Detektieren eines fehlerhaften Zustandes einer Kraftfahrzeugbatterie, wobei das Fahrzeug einen Verbrennungsmotor aufweist, der während einer Antriebsphase von einem an der Fahrzeugbatterie angeschlossenen Anlasser in Drehung versetzt wird, und diese Antriebsphase während einer Startphase des Motors abläuft, welches Verfahren darin besteht, den Verlauf der Entladespannung an den Klemmen der Batterie in Abhängigkeit von der Zeit zu analysieren, und die folgenden Schritte aufweist:
- Messen zweier aufeinanderfolgender entsprechender Werte U₁ und U₂ der Entladespannung der Batterie während der Antriebsphase des Kraftfahrzeugmotors,
- Berechnen der Differenz der gemessenen Spannungswerte und
- Bestimmen des Ladezustandes der Batterie ausgehend von dieser Differenz, wobei das Verfahren **dadurch gekennzeichnet ist, dass** die Messung der aufeinanderfolgenden entsprechenden Werte U₁ und U₂ in sich entsprechenden Zeitpunkten zweier aufeinanderfolgender Arbeitszyklen des Motors durchgeführt wird und dass die gebildete Spannungsdifferenz genau U₁ - U₂ ist.

2. Verfahren nach Anspruch 1, **dadurch gekennzeichnet, dass** die sich entsprechenden Zeitpunkte der beiden aufeinanderfolgenden Arbeitszyklen des Motors obere Totpunkte sind.

3. Verfahren nach Anspruch 1 oder 2, **dadurch gekennzeichnet, dass** die Batterie für fehlerhaft erklärt wird, wenn die Differenz der gemessenen Spannungen U₁ - U₂ kleiner oder gleich Null ist.

4. Verfahren nach Anspruch 1, **dadurch gekennzeichnet, dass** es ferner darin besteht:
- den progressiven Mittelwert der gemessenen Entladespannungen (U₁; U₂) zu berechnen und
- hieraus zu schließen, dass die Batterie fehlerhaft ist, wenn die erste Ableitung dieses Mittelwertes kleiner oder gleich Null ist.

5. Verfahren nach einem der vorhergehenden Ansprüche, **dadurch gekennzeichnet, dass** es darin besteht:
- den fehlerhaften Zustand der Batterie zu verifizieren, wenn der Mittelwert der Entladespannungen während der Antriebsphase kleiner als eine in Abhängigkeit von einer Batterietemperatur vorgegebene Schwelle ist.

6. Verfahren nach einem der Ansprüche 1 bis 4, **dadurch gekennzeichnet, dass** es darin besteht:
- zu erklären, dass die Batterie "alt" ist, wenn die Batterie als fehlerhaft erklärt wird, und dass ein Mittelwert der Entladespannungen während der Antriebsphase kleiner als ein in Abhängigkeit von der Temperatur vorgegebener Schwellenwert ist, was es erlaubt, den Fahrer zu informieren, dass er die Batterie bald auswechseln muss.

## Claims

1. Method for detecting weakness of a battery of a motor vehicle, said vehicle having an internal combustion engine driven in rotation during a drive phase by a starter motor connected to the vehicle's battery, this drive phase occurring during the engine ignition phase, said method consisting of analysing the evolution of the discharge voltage at the terminals of the battery over time and including the following stages:
- measuring two successive battery discharge voltages, respectively U₁ and U₂, during the drive phase of the engine of the motor vehicle,
- calculating the difference between the voltages measured, and
- determining the state of charge of the battery on the basis of this difference,
said method being **characterised in that** the measurement of the two successive values, respectively U₁ and U₂, is taken at corresponding instants in two consecutive engine cycles and **in that** the resultant difference in voltage is strictly U₁-U₂.

2. Method according to Claim 1, **characterised in that** the corresponding instants in two consecutive engine cycles are top dead centres.

3. Detection method according to Claims 1 or 2, **characterised in that** the battery is declared to be weakening if the difference in the voltages measured U₁-U₂ is equal to or less than zero.

4. Detection method according to Claim 1, **characterised in that** it also consists of:
- calculating the progressive average of the discharge voltages measured (U₁; U₂), and
- determining that the battery is weakening if the first derivative of this average is less than or equal to zero.

5. Detection method according to any one of the preceding claims, **characterised in that** it consists of:
- confirming weakness of the battery if the average discharge voltage during the drive phase is less than a predetermined threshold, depending on the temperature of the battery.

6. Detection method according to any one of Claims 1 to 4, **characterised in** it that consists of:
- declaring that the battery is "old" if the battery is declared to be weakening and the average discharge voltage during the drive phase is less than a predetermined threshold depending on the temperature, allowing the driver to be informed that he will have to change the battery soon.
